# EUROPEAN PATENT SPECIFICATION

(11) **EP 0 315 597 B1**
(45) Date of publication and mention of the grant of the patent: **09.06.1993**
(21) Application number: 88830453.2
(22) Date of filing: 26.10.1988
(51) Int. Cl.: H02P 7/00

(54) **Analog multiplex for sensing the magnitude and sense of the current through a H-bridge stage utilizing a single sensing resistance**
Analoger Multiplexer zum Bestimmen von Grösse und Richtung des Stromes durch eine H-Brücke mittels eines einzigen Messwiderstands
Multiplex analogue pour déterminer l'amplitude et la direction d'un courant dans un pont en forme de H, utilisant une seule résistance de mesure

(30) Priority: 02.11.1987 IT 8366787
(43) Date of publication of application: 10.05.1989
(73) Proprietor: SGS-THOMSON MICROELECTRONICS s.r.l., 20041 Agrate Brianza (Milano) (IT)
(72) Inventor: Rossi, Domenico, I-27024 Cilavegna (IT); Cuomo, Andrea, I-20122 Milano (IT)
(74) Representative: Pellegri, Alberto

(56) References cited:
- EP-A- 0 291 813
- NL-A- 7 106 851
- RADIO FERNSEHEN ELEKTRONIK, vol. 29, no. 8, 1980, pages 521-524; H. KRAUSE et al.: "Analogschalter und -multiplexer mit MOSFET"
- APEC '87 SECOND ANNUAL IEEE APPLIED POWER ELECTRONICS CONFERENCE AND EXPOSITION, San Diego, California, 2nd - 6th March 1987, pages 230-237, IEEE, New York, US; C. MANN et al.: "Configurable high current, high voltage power integrated circuits for control and drive of DC motors, stepper motors and other inductive loads"

## Description

The present invention relates to circuits for a switching mode driving of a load and in particular to circuit arrangements for controlling the current being delivered to the load.

Apparatuses for controlling electric motors and more generally for delivering a current to inductive loads utilize the so-called Pulse Width Modulation technique (PWM). This technique is implemented by means of a "H-bridge" stage utilizing a square-wave driving signal, whose frequency and duty-cycle are controlled by means of a clock signal, and the inverted signal thereof which are applied, respectively, to two pairs of switches arranged in a bridge configuration and operatively switching the load between a supply and a ground or a virtual ground node of the bridge stage. For implementing a system for monitoring and controlling the current being delivered to the load, sensing resistances, connected between the virtual ground nodes of the two branches of the H-bridge stage and the real ground of the circuit are frequently used. These sensing resistors must necessarily be power components, suitable to withstand the current which flows through the load, and for this reason are almost exclusively discrete components, connected externally to an integrated driver circuit and generally representing a remarkable cost factor of the apparatus also because they must often possess well determined precision and temperature coefficient characteristics and be exempt of any appreciable inductance.

The article entitled: *"Configurable High Current, High Voltage Power Integrated Circuis For Control And Drive Of DC Motors, Stepper Motors And Other Inductive Loads",* by Christopher Mann and Phil Davies (APEC '87 Second Annual IEEE Applied Power Electronics Conference And Exposition) 6th March 1987, page 230-237, IEEE, New York, U.S., contains an ample description of several integrated devices for controlling and driving DC motors, stepper motors and other inductive loads. In particular, on page 236, in figures 12 and 13, systems are shown for driving a two-phase stepper motor and a dual solenoid, respectively, both employing two external current sensing resistors, as customarily done in these driver systems.

The circuit for sensing the magnitude and direction according to the present invention is described in Claim 1 and determines the magnitude and direction of the current being delivered to a load of a H-bridge stage by utilizing a single sensing resistor connected between a common virtual ground node of the driving bridge circuit and a real ground node.

The different aspects and advantages of the invention in relation to the known technique will be more easily understood through the following description with reference to a series of drawings, wherein:
**Figure 1** is a principle circuit diagram of a H-bridge stage provided with a circuit for sensing the magnitude and direction of the electric current flowing through the load, according to a known technique;
**Figures 2 and 3** show two typical signal diagrams representative of the circuit of Fig. 1;
**Figure 4** shows a principle circuit diagram of a H-bridge stage utilizing a circuit for sensing the magnitude and direction of the electric current through the load in accordance with the present invention;
**Figure 5** is a signal diagram representative of the circuit of Fig. 4;
**Figure 6** is a circuit diagram of am embodiment of the circuit of Fig. 4 utilizing analog switches implemented by means of MOS transistors.

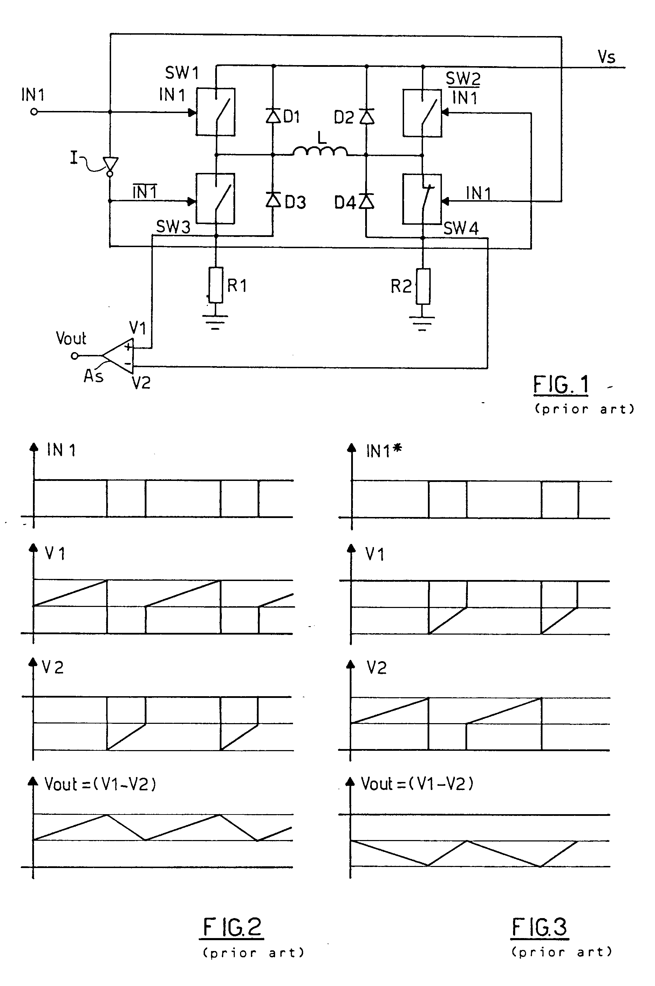

A H-bridge stage for driving an inductive load L is shown in Fig. 1 using conventional symbols. The stage is formed by four switches: SW1, SW4 and SW2, SW3; driven, repectively, by a driving signal IN1 and by the inverted signal thereof I̅N̅1̅, the latter being obtained by means of an inverter I. For completeness's sake recirculation diodes D1, D4 and D2, D3 are also shown in Fig. 1. The two pairs of switches (namely SW1, SW4 and SW2, SW3) arranged in a bridge configuration functionally switch the load L between the supply node Vs, and virtual ground nodes, (which in the case shown in Fig. 1 coincide with the nodes (V1) and (V2), in function of a certain "duty cycle", which is in turn determined by the relative duration of the driving signals IN1 and I̅N̅1̅ (in accordance with a Pulse Width Modulation technique).

The control of the driving of the load is based upon the sensing of the magnitude (modulus) and of the sense (direction) of the current flowing through the load L.

According to a widely used technique embodied in the circuit of Fig. 1, the sensing circuit employs two distinct sensing resistors R1 and R2 connected, respectively, between the two virtual ground nodes (V1) and (V2) of the H-bridge circuit and a real ground node of the circuit. The voltage signals across these two sensing resistors R1 and R2 (i.e. the potentials V1 and V2) are fed to the inputs of a differential sensing amplifier (Aₛ).

The representative signal diagrams of the circuit are shown in Figures 2 and 3. By supposing to operate with a "duty-cycle" of the input signal different from 50% and therefore to adjust the current through the load L (which is presumed inductive) to an average value different from the operating situation may be depicted by means of the time diagrams of Fig. 2 which represent a drive signal IN1 (having a certain duty-cycle), the voltages of the two virtual ground nodes, V1 and V2, and the output voltage of the differential amplifier Aₛ. In the case illustrated, the output signal of the amplifier will have a positive polarity and the amplitude of this signal (Vout) will be proportional to the magnitude of the current flowing through the load L.

Viceversa, by supposing to apply a driving signal IN1*, complementary to the driving signal IN1 of the situation depicted in the diagrams of Fig. 1, the corresponding signals will take the form depicted in the diagrams of Fig. 3. Basically the output signal of the amplifier Aₛ will have the same amplitude but an inverted, negative polarity.

As easily recognized, according to such a sensing circuit of the prior art, the sensing of the direction of the current flowing through the load could not take place if only one sensing resistor is used.

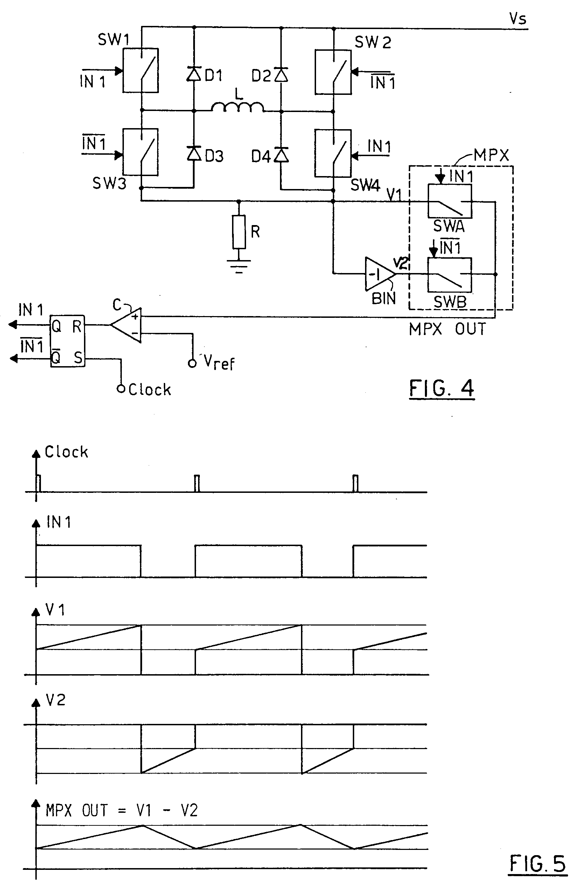

This is what is made possible by the sensing circuit of the present invention which is schematically depicted in Fig. 4. In this figure as well as in the others, the same symbols and numerals are utilized for identifying recurring or equivalent components, common to the circuits shown in the different figures.

As it may be observed, the circuit of the invention utilizes a single sensing resistor R connected between a single common virtual ground node (V1) and a real ground node of the circuit. The necessary reconstruction of the complete information of the current delivered to the load L of the bridge stage takes place by means of an analog multiplex (MPX) having two inputs, formed by two switches SWA and SWB) which are respectively driven by the clocked driving signal IN1 and by its inverted signal I̅N̅1̅, to the inputs of which are applied, respectively, the common virtual ground node's voltage signal (V1 during a first phase) and an inverted signal thereof (V2 during a second phase) which is obtained by means of an inverting analog buffer BIN. The output signal of the multiplex (MPX OUT) is then fed to the non inverting input (+) of a comparator, to the other (inverting) input (-) of which a control voltage (Vref) is suitably applied.

As it may be easily observed, once a certain control voltage Vref is set, the outupt signal of the comparator C will contain the desired information on the magnitude and direction of the electric current flowing through the load L of the H-bridge stage. The amplitude of the output signal of the comparator is proportional to the magnitude of the current while the polarity thereof (in respect to the polarity of the reference or control voltage Vref) is indicative of the sense of the current. This is figuratively shown in Fig. 5 by means of the time diagrams of the different signals representative of the circuit of Fig. 4, as it will be described in more detail later on.

The PWM control and adjustment loop may be completed in a conventional manner as shown in Fig. 4 by feeding the output signal of the comparator C to an input (R) of a flip-flop Q, to the other input (S) of which a timing clock signal is applied. This allows to invert or not to invert the sense signal of the monitored current syncronously with the driving signal IN1.

The clock signal, the driving signal IN1, the two "phases" of the potential of the common virtual node namely: V1 which is fed directly to one input multiplex MPX and V2 which is inverted by the inverter BIN before being fed to the other input of the multiplex MPX, and the output signal MPX OUT of the multiplex MPX are depicted in the time diagram of Fig. 5.

The amplitude of the MPX OUT signal will be proportional to the magnitude of the current which flows through the load L of the bridge stage, while the polarity of the corresponding output signal of the comparator C will be determined by the polarity of the voltage Vref which is applied to the other input (-) of the comparator C.

Therefore the inversion of the direction of the current flowing through the load is easily implemented by simply inverting the polarity of Vref.

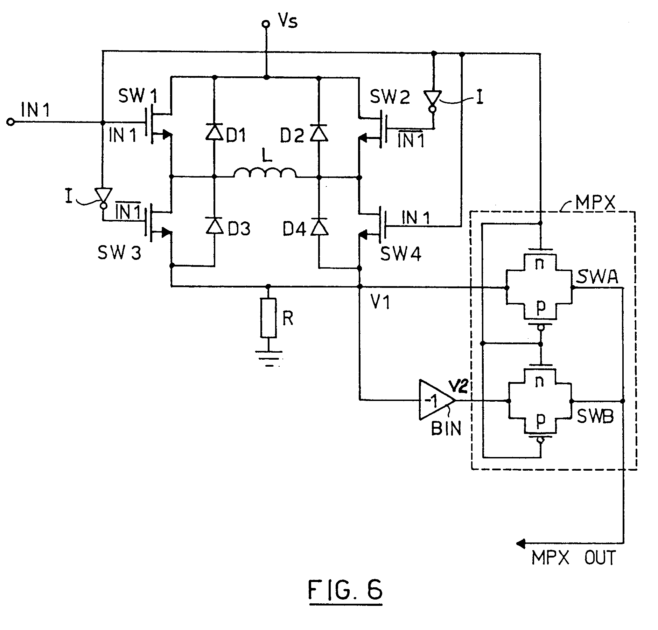

The circuit of the invention is particularly advantageous in those applications which contemplate the integration of the H bridge stage either by means of integrated power bipolar transistors or MOS transistors. In these embodiments, the multiplex will be conveniently made by means of two integrated analog switches. Such an integrated circuit is shown in Fig. 6, wherein the power switches of the bridge stage (SW1, SW4 and SW3, SW2) are made with as many power MOS transistors, while the multiplex MPX is formed by two analog switches each being formed by a pair of complementary MOS transistors one with a N-channel and the other with a P-channel), i.e. in CMOS technology.

## Claims

1. A circuit for sensing the magnitude and direction of an electric current flowing through a load (L) driven in a switching mode by an H-bridge stage by means of a clocked square-wave driving signal (IN1) and the inverted driving signal (I̅N̅1̅) which are applied, respectively, to two pairs of analog switches (SW1-SW4, SW2-SW3) arranged in an H-bridge configuration and having recirculation diodes (D1, D2, D3, D4) connected across said switches, said switches switching the load (L) between a supply node (Vs) and a virtual ground node (V1) of the stage and the circuit utilizing resistive sensing means (R) connected between the H-bridge stage and a ground node, characterized by said circuit comprising:
a single sensing resistor (R) connected between a virtual ground node (V1) and a real ground node of the circuit;
an analog, two input, multiplex (MPX) including two switches (SWA, SWB) driven, respectively, by the driving signal (IN1) and by the inverted driving signal (I̅N̅1̅), the input corresponding to the switch (SWA) driven by the driving signal being connected to the virtual ground node (V1) and the input corresponding to the switch (SWB) driven by the inverted driving signal (I̅N̅1̅) being connected to the output (V2) of an inverting analog buffer (BIN) having an input connected to said virtual ground node (V1); and
a comparator (C) having two input terminals and an output terminal, the output (MPX OUT) of said analog multiplex being connected to a first input terminal of said comparator and a reference voltage (Vref) being applied to a second input terminal of said comparator.

2. The sensing circuit according to claim 1, wherein said multiplex is formed by a pair of analog switches made with MOS transistors.

3. The sensing circuit according to claim 1, characterized in that the output terminal of said comparator (C) is connected to an input terminal of a flip-flop, to another input terminal of which a clock signal (Clock) is applied;
an output signal of said flip-flop constituting said driving signal (IN1) and the polarity of said reference voltage (Vref) determining the direction of the current flowing through the load (L) of the bridge stage.

## Patentansprüche

1. Schaltung zum Erfassen von Größe und Richtung eines elektrischen Stroms, welcher durch eine Last (L) fließt, die in einer Schaltbetriebsweise über eine H-Brücken-Stufe mittels eines getakteten Rechteck-Treibersignals (IN1) und des invertierten Treibersignals (IN1) gespeist wird, welche an zwei Paare von Analogschaltern (SW1-SW4, SW2-SW3) angelegt werden, die in H-Brücken-Anordnung angeordnet sind und parallel zu den Schaltern geschaltete Rückstromdioden (D1, D2, D3, D4) aufweisen, wobei die Schalter die Last (L) zwischen einem Spannungsversorgungsknoten (Vs) und einem virtuellen Masseknoten (V1) der Stufe schalten und die Schaltung eine zwischen die H-Brücken-Stufe und einen Masseknoten geschaltete Widerstands-Meßeinrichtung (R) verwendet,
**dadurch gekennzeichnet,**
daß die Schaltung aufweist:
Einen einzigen Meßwiderstand (R), der zwischen einen virtuellen Masseknoten (V1) und einen realen Masseknoten der Schaltung geschaltet ist;
einen zwei Eingänge aufweisenden Analog-Multiplexer (MPX) mit zwei Schaltern (SWA, SWB), die durch das Treibersignal (IN1) bzw. durch das invertierte Treibersignal (I̅N̅1̅) angesteuert werden, wobei der Eingang, welcher dem durch das Treibersignal angesteuerten Schalter (SWA) entspricht, an den virtuellen Masseknoten (V1) angeschlossen ist, während der dem von dem invertierten Treibersignal (IN1) angesteuerten Schalter (SWB) entsprechende Eingang an dem Ausgang (V2) eines invertierenden Analog-Puffers (BIN) angeschlossen ist, der mit seinem Eingang an den virtuellen Masseknoten (V1) geschaltet ist; und
einen Vergleicher (C) mit zwei Eingangsanschlüssen und einem Ausgangsanschluß, wobei der Ausgang (MPX OUT) des Analog-Multiplexers an einen ersten Eingangsanschluß des Vergleichers angeschlossen ist, während eine Bezugsspannung (Vref) an den zweiten Eingangsanschluß des Vergleichers gelegt wird.

2. Erfassungsschaltung nach Anspruch 1, bei der der Multiplexer aus einem Paar Analogschaltern gebildet ist, die mit MOS-Transistoren hergestellt sind.

3. Erfassungsschaltung nach Anspruch 1,
**dadurch gekennzeichnet,**
daß der Ausgangsanschluß des Vergleichers (C) an einen Eingangsanschluß eines Flipflops angeschlossen ist, während an den anderen Eingangsanschluß ein Taktsignal (TAKT) gelegt wird;
daß ein Ausgangssignal des Flipflops das Treibersignal (IN1) bildet und die Polarität der Bezugsspannung (Vref) die Richtung des durch die Last (L) der Brückenstufe fließenden Stroms bestimmt.

## Revendications

1. Circuit de détection de l'amplitude et du sens du courant électrique circulant dans une charge (L) alimentée en mode de découpage par un étage de pont en H au moyen d'un signal de commande carré synchronisé sur une horloge (IN1) et d'un signal de commande inversé (I̅N̅1̅) qui sont appliqués, respectivement, à deux paires de commutateurs analogiques (SW1-SW4, SW2-SW3) agencés en une configuration de pont en H et comprenant des diodes roue libre (D1, D2, D3, D4) connectées aux bornes de ces commutateurs, ces commutateurs commutant la charge (L) entre un noeud d'alimentation (Vs) et un noeud de masse virtuelle (V1) de l'étage, ce circuit utilisant des moyens de détection résistifs (R) connectés entre l'étage de pont en H et un noeud de masse, caractérisé en ce que ce circuit comprend :
une résistance de détection unique (R) connectée entre un noeud de masse virtuelle (V1) et un noeud de masse réelle du circuit ;
un circuit de multiplexage analogique à deux entrées (MPX) comprenant deux commutateurs (SWA, SWB) commandés respectivement par le signal de commande (IN1) et le signal de commande inversé (I̅N̅1̅), l'entrée correspondant au commutateur (SWA) commandé par le signal de commande étant connectée au noeud de masse virtuelle (V1) et l'entrée correspondant au commutateur (SWB) commandé par le signal de commande inversé (I̅N̅1̅) étant connectée à la sortie (V2) d'un étage inverseur analogique (BIN) ayant une entrée connectée au noeud de masse virtuelle (V1) ;
un comparateur (C) ayant deux bornes d'entrée et une borne de sortie, la sortie (MPX OUT) du circuit de multiplexage analogique étant connectée à une première borne d'entrée du comparateur et une tension de référence (Vref) étant appliquée à une seconde borne d'entrée du comparateur.

2. Circuit de détection selon la revendication 1, dans lequel le multiplexeur est constitué d'une paire de commutateurs analogiques formés de transistors MOS.

3. Circuit de détection selon la revendication 1, caractérisé en ce que la borne de sortie du comparateur (C) est connectée à une borne d'entrée d'une bascule, à une autre borne d'entrée de laquelle est appliqué un signal d'horloge (Clock) ; le signal de sortie de la bascule constituant le signal de commande (IN1) et la polarité de la tension de référence (Vref) déterminant le sens du courant circulant dans la charge (L) de l'étage en pont.
